# EUROPEAN PATENT SPECIFICATION

(11) **EP 2 850 730 B1**
(45) Date of publication and mention of the grant of the patent: **19.12.2018**
(21) Application number: 13727689.5
(22) Date of filing: 14.05.2013
(51) Int. Cl.: H03K 17/97, H01H 36/00, H01H 23/30

(54) **CONTACTLESS SWITCH WITH STATIONARY VANE**
KONTAKTLOSER SCHALTER MIT EINER LEITSCHAUFEL
COMMUTATEUR SANS CONTACT AVEC PALETTE STATIONNAIRE

(30) Priority: 14.05.2012 US 201261646368 P
(43) Date of publication of application: 25.03.2015
(73) Proprietor: Eaton Corporation, Cleveland, OH 44122 (US); Lee, Davin R., Milwaukee, WI 53098 (US); Juds, Mark A., New Berlin, WI 53146 (US)
(72) Inventor: LEE, Davin, R., Milwaukee, WI 53098 (US); JUDS, Mark, A., New Berlin, WI 53146 (US)
(74) Representative: Wimmer, Hubert
(86) International application number: PCT/US2013/040882
(87) International publication number: WO 2013/173286

(56) References cited:
- EP-A1- 2 390 893
- EP-A1- 2 410 657
- DE-A1-102008 050 866
- FR-A1- 2 823 368

## Description

### FIELD OF THE INVENTION

This application is directed to electrical switching mechanisms.

### BACKGROUND

Electrical switches, including rocker-type switches, can operate by detecting switch position, which in turn can be dictated by a user's engagement of a moveable switch button. Detection of deliberate actuation by the user is desirable, as is differentiation of deliberate actuation of such a button from button movement that may not be intended by the user.

Attention is drawn to DE 10 2008 050 866 A1, which shows a rocker switch having a pivotable actuator, having a magnetic latching unit made of a stationary magnet arrangement and a magnet arrangement displaceable by the actuator, and having a magnetically controllable switching element arrangement. The displaceable magnet arrangement is formed by a single switching magnet and the stationary magnet arrangement is formed by a plurality of latching magnets corresponding to the number of latching positions, and the switching element arrangement has a plurality of switching elements corresponding to the number of latching positions, and an effective magnetic shielding plate is disposed between the displaceable magnet arrangement on one side and the switching element arrangement on the other side. Furthermore, EP 2 410 657 Al shows to a tilting operation type input device having shafts each being fitted into fitting holes of a knob fitting member and the respective shafts are pivotally supported to bearing wall portions of a housing. An operation knob covers the exterior of the knob fitting member, and the operation knob and the knob fitting member are integrated by fastening fixation screws to the shafts. A magnet of a detection unit and a magnetic sensor approach and face each other in a region cutting across a rotation center line of the operation knob. When rotationally operating the operation knob, since a driving portion of the knob fitting member drives the magnet, the magnetic sensor can detect a variation of the magnetic field.

### SUMMARY

In accordance with the present invention, a switch as set forth in claim 1 is provided. Further embodiments of the invention are inter alia claimed in the dependent claims. According to one aspect of the present teachings, a switch may include a switch housing, and a button moveably mounted to the housing. A profile is disposed on the underside of the button and has a profile contour that provides the tactile feel of the button as it is engaged by the user. A spring biased plunger has one end that engages the profile contour. A printed circuit board is mounted to the housing and includes a magnet sensor. A magnet holder includes at least one magnet. A vane interrupter has at least one passage having an opening proximate to a magnetic sensor. The magnet holder is moveably mounted to the housing such that the magnet is selectively moveable at least partially within the passage to a position where the magnet can be detected by the sensor.

### BRIEF DESCRIPTION OF THE DRAWINGS

In the accompanying drawings, structures are illustrated that, together with the detailed description provided below, describe aspects of the claimed invention. Like elements are identified with the same reference numerals. It should be understood that elements shown as a single component may be replaced with multiple components, and elements shown as multiple components may be replaced with a single component. The drawings are not to scale and the proportion of certain elements may be exaggerated for the purpose of illustration.
**Figure 1** is a perspective view of a multi-switch assembly according to the present disclosure.
**Figure 2** is a partially exploded view of the multi-switch assembly shown in Figure 1.
**Figure 3** illustrates an exploded view of the multi-switch assembly shown in Figure 1.
**Figures 4-6** are sectional views of the multi-switch assembly shown in Figure 1 in the center, partially down, and fully down position, showing the magnet holder, magnets, sensors, a ferrous vane.
**Figure 7** is an alternative section view of the multi-switch assembly shown in Figure 1 showing the plunger and profile.
**Figure 8** is a sectional view of a switch according to the present disclosure.
**Figure 9** is a view of a vane interrupter.
**Figure 10** is a graph of simulation of the magnetic field versus rocker button angle for a switch according to the present disclosure.

### DETAILED DESCRIPTION

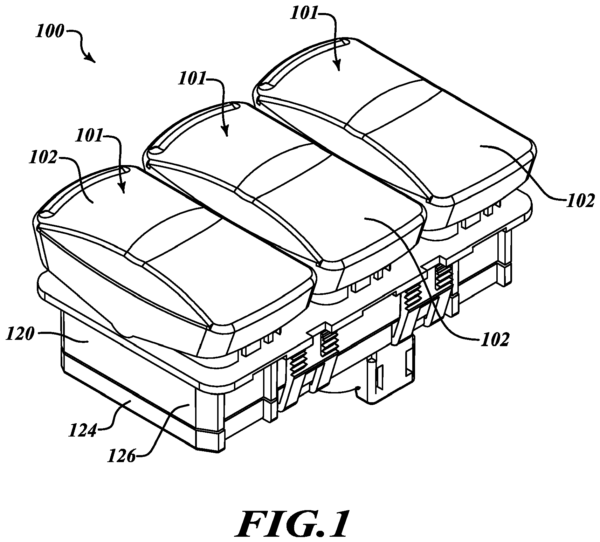

Figure 1 illustrates a multi-switch assembly 100 according to the present disclosure. The illustrated assembly 100 has three switches 101, all three of which share similar internal mechanisms and electronics beneath buttons 102, which serves as an interface for a user. In the illustrated example, buttons 102 are rocker-type buttons. However other types of buttons may be implemented according to the present teachings. Further, any one or more switches 101 in an assembly may be implemented according to the present disclosure, and the internal mechanisms and electronics need not be identical.

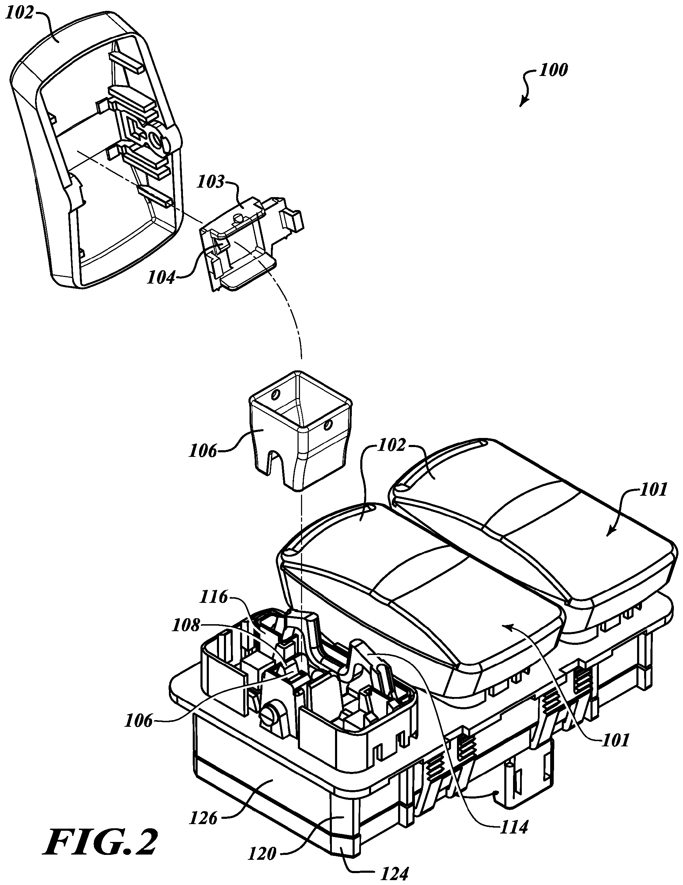

Figure 2 illustrates a partially exploded view of assembly 100 of Figure 1. A switch profile member 103 is disposed on the underside of button 102. Switch profile member 103 has a profile contour 104 is disposed on the underside of button 102 and interacts with a plunger 106 that is biased toward profile contour 104. The contact made by end 108 of biased plunger 106 against profile contour 104 dictates the tactile response of button 102 felt by the user. The illustrated example shows but one example contour 104, and other contours may be implemented according to the present teachings. Several forms of switching action may be provided by selecting a corresponding profile contour 104. Such switching action can include, for example, momentary, sustained, 2 position or 3 position.

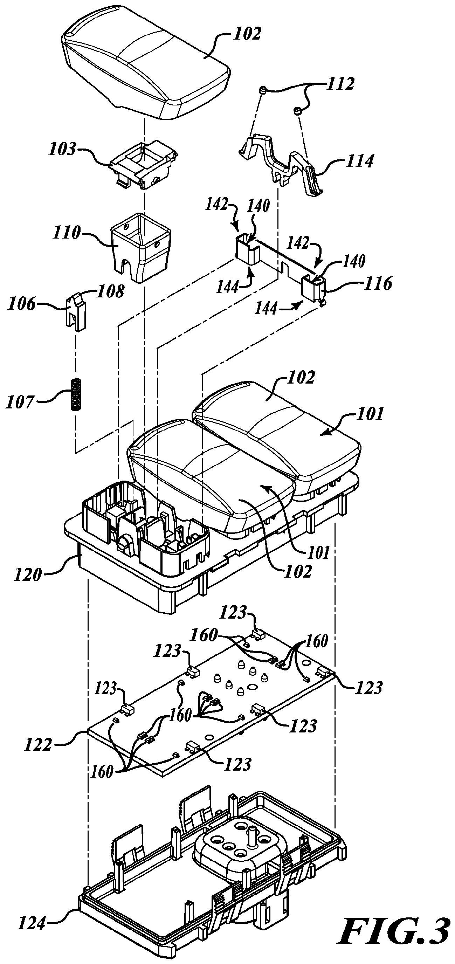

With reference to Figure 3 a multi-switch assembly 100 includes buttons 102, a switch profile member 103, a plunger 106, a plunger spring 107, a plunger seal 110, magnets 112, a magnet holder 114, a vane interrupter 116, a frame 120, a printed circuit board ("PCB") assembly 122 and a back cover 124. Plunger seal 110 is a dust-resistant boot that reduces dust and dirt contamination of the plunger 106 and plunger spring 107. According to one aspect of the present teachings, plunger seal 110 can include an elastic material.

PCB assembly 122 includes electromagnetic sensors 123. According to one aspect of the present teachings, the sensors are Hall Effect sensors 123 configured to detect magnets 112. Hall Effect sensors 123 act as transducers responsive to the magnetic field of magnets 112, which can be permanent magnets according to one aspect of the present teachings. According to one aspect of the present teachings, back cover 124 and frame 120 together form a housing 126 in which PCB assembly 122 is mounted. When housing 126 is assembled, PCB assembly 122 is mounted within housing 126, and sensors 123 are mounted within housing, disposed beneath magnets 112. Other electromagnetic sensors may be implemented, such as any sensor that can detect electromagnetic field strength. In other aspects, the sensors may be electromagnetic field sensors that act as transducers generating a signal proportional to one or more aspects of the electromagnetic fields generated by magnets. According to other aspects of the present teachings, housings may be formed of a single piece, or more than two pieces. In addition, the PCB assembly 122 may be mounted to the housing in different ways and in different orientations. In one non-limiting example, PCB assembly 122 can be mounted underneath the housing.

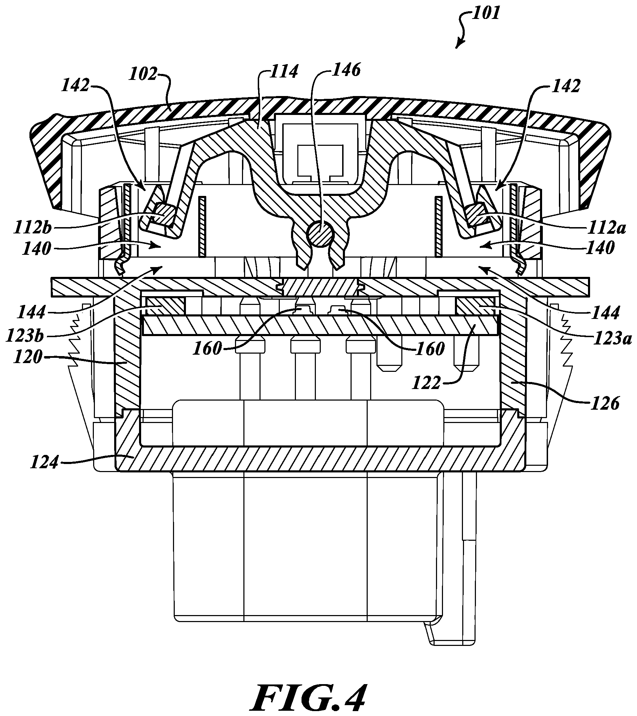

With reference to Figure 4, a switch 101 of assembly 100 in its center, or neutral position. Hall-effect sensors 123a and 123b are mounted on PCB assembly 122, which in turn is mounted to housing 126. Hall Effect sensors 123a, 123b are mounted underneath frame 120, which separates sensors 123a, 123b from permanent magnets 112a, 112b in holder 114. Magnets 112a, 112b are disposed inside passages 140 of ferrous vane interrupter 116 having a rectangular cross-section. Passages 140 have openings 142 distal to sensors 123 relative to proximate openings 144. When magnets 112a, 112b are disposed within passages 140, between openings 142 and 144, vane interrupter 116 attenuates the magnetic field of permanent magnets 112a, 112b at Hall-effect sensors 123a, 123b to a value lower than would otherwise be felt without the presence of vane interrupter 116. In the illustrated position, sensors 123a, 123b and the connected electronics on PCB assembly 122 detect that the switch is not in an activated position.

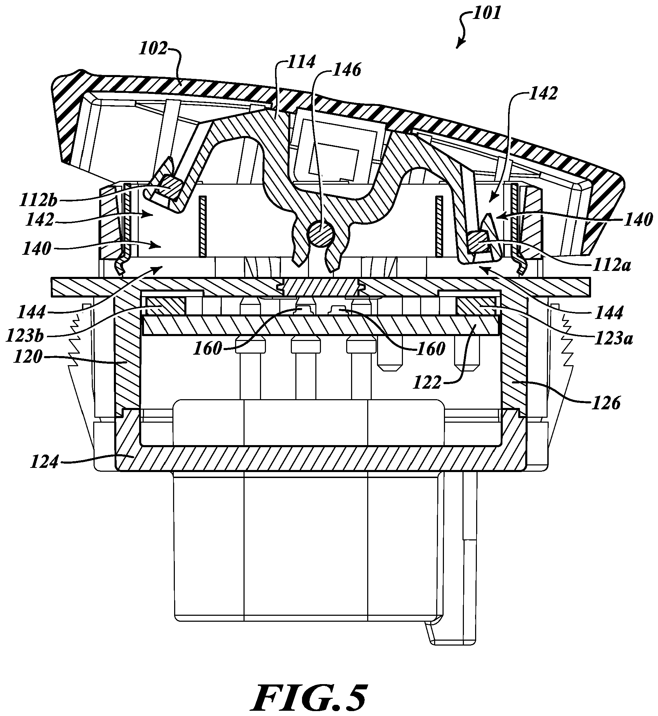

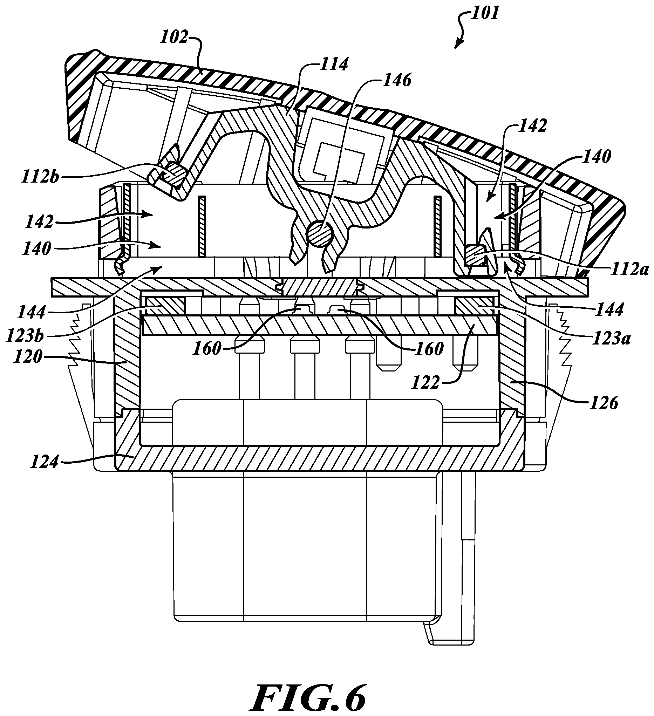

As button 102 is rotated clockwise from the center position shown Figure 4 to the partially depressed position shown in Figure 5, rocker button 102 pushes magnet holder 114 causing it to rotate about pin 146. Magnet 112a has moved closer to Hall-effect sensor 123a, and closer to opening 144. As magnets 112a, 112b move closer to openings 144a, 144b, the attenuating effect of vane interrupter 116 diminishes. As a result of the change in position, the intensity of the magnetic field at sensor 123a rises more rapidly than would otherwise occur without vane interrupter 116. This permits sensor 123a to detect an activation of switch 101 before switch 101 is fully rotated in the clockwise direction to the position shown in Figure 6.

Figure 6 shows switch 101 at its terminal position at the end of its travel in the clockwise direction. In this position, vane interrupter 116 has little effect on the magnetic field surrounding magnet 112a, and the magnetic field at sensor 123a is at its highest intensity. In the illustrated position, the magnetic field at sensor 123b is at its lowest intensity as magnet 112b is at its furthest position distal to sensor 123b.

Rocker button 102 of switch 101 illustrated in Figure 6 can be rotated in the opposite direction. When moved in the counterclockwise direction, magnet 112a moves inside of passage 140 of vane interrupter 112, which attenuates the magnetic field of magnet 112a and causes the field detected by sensor 123a to drop much more rapidly than without vane 116, until sensor 123a detects switch 101 to be deactivated before button 102 of switch 101 reaches its "center" position. The user can further depress button 102 in the counterclockwise direction to another actuated position where magnet 112b is sufficiently close to sensor 123b to detect actuation. Like the clockwise rotation of switch 101, the counterclockwise rotation can result in sensor 123b detecting the magnetic field of magnet 112b before magnet 112b reaches a terminal position closest to sensor 123b. As with the end of travel in the clockwise position, when the switch reaches the end of travel in the counterclockwise direction, magnet 112a is at its furthest position from sensor 123a when magnet 112b is at its terminal position closest to sensor 123b. According to an aspect of the present teachings, no contact between Hall-effect sensors 123 and magnets 112 is necessary for switch 101 to function. Further, none of magnets 112 or holder 114 must penetrate the switch housing in order to effectuate switching.

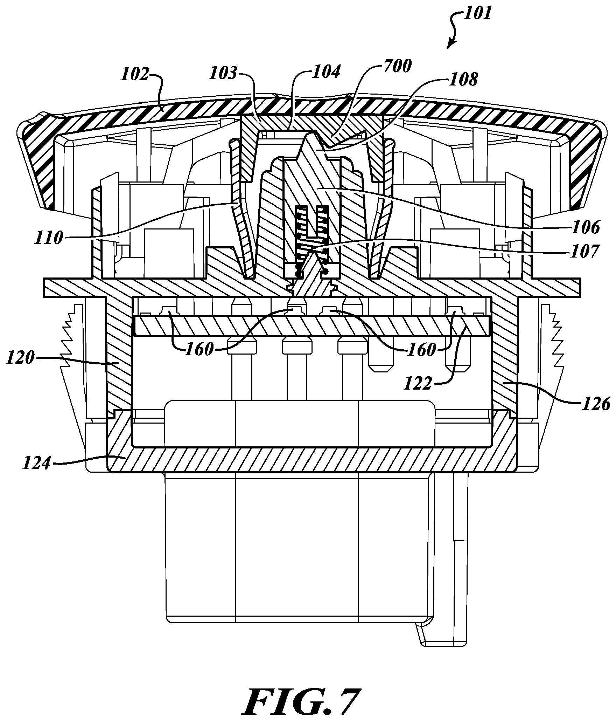

With reference to Figure 7, plunger 106 is biased against profile member 103 by spring 107. Tapered end 108 of plunger 106 makes contact against profile contour 104 of profile member 103. In the illustrated example, protrusion 700 causes the button to provide a clicking sensation to the user when the button is depressed in the counterclockwise direction from the illustrated position. Other profile contours can be utilized according to the present disclosure.

The illustrated profile member 103 can be subtituted with another profile member having a different shape profile contour than the illustrated profile contour 104. Switch profile members 103 may be selected according a user's preferred switching behavior for a particular switch 101. Combinations of different switch profile members 103 may be used in assemblies such as assembly 100. Profile members 103 can be secured to the underside of button 102 by snap-fitting, molding, welding or a variety of other methods. Such construction permits the use of a common button 102 and with a variety of different profile members 103. Reference may be made to U.S. Patent Nos. 7,026,565 and 7,952,044, which are incorporated by reference as if fully set forth herein.

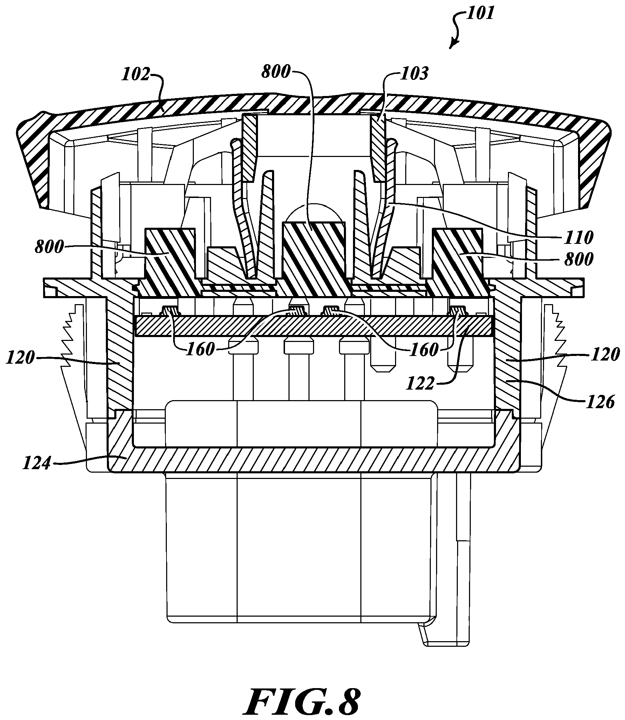

With reference to Figure 8, light emitting diodes (LEDs) 160 can be affixed to PCB assembly 122. LEDs 160 emit light through rocker button 102 by passing the light through light pipes 800 constructed from a transparent material that directs the emitted light toward button 102. Light pipes 800 can be molded directly into frame 120 or can be a separate discrete component.

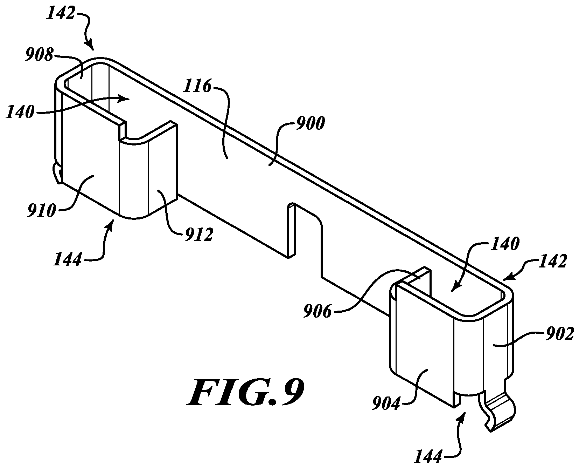

With reference to Figure 9, vane interrupter 116 is formed from sheet metal to have a plurality of walls forming two passages 140. First wall 900 forms part of both passages 140. One of passages 140 is partially formed by second wall 902, third wall 904 and fourth wall 906, and the other passage is partially formed by fifth wall 908, sixth wall 910 and seventh wall 912. Passages 140 almost completely surround magnets that travel within passages 140. However, a vane interrupter need not completely surround the magnets to have the desired effect. In one aspect of the present teachings, a vane interrupter can partially surround magnets that are moveable toward and away from Hall Effect sensors. Further, while the illustrated passages 140 have a rectangular cross-sectional shape, other shapes may be implemented, such as circular cross sections, triangular cross-sections, and several other possible cross-sectional shapes. According to one aspect of the present teachings, vane interrupter 116 may be constructed from iron. In another aspect, vane interrupter 116 may be made of any magnetic material, including but not limited to magnetic stainless steel.

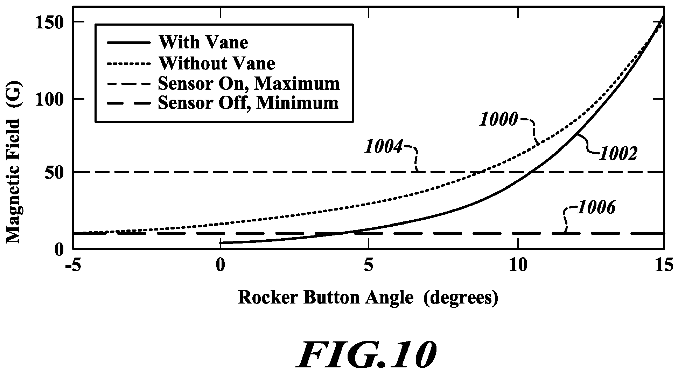

With reference to Figure 10, according to one aspect of the present teachings, a graph of magnetic field measured in Gauss (G) versus rocker button rotation angle from a simulation of a switch, for example one configured such as switch 101, with and without a stationary vane interrupter, such as interrupter 116. Line 1000 reflects the response without a vane interrupter and line 1002 reflects the response with a vane interrupter. Line 1004 illustrated the maximum magnetic field intensity required at the sensor to activate the switch, while line 1006 is the minimum value of magnetic field intensity required to deactivate the switch. Without the vane interrupter, the maximum magnetic field intensity required at the sensor to activate the switch is achieved at about 9 degrees of rotation, whereas with the vane interrupter, the maximum magnetic field intensity required at the sensor to activate the switch is achieved at about 11 degrees of rotation, a difference of about 2 degrees. Further, without the vane interrupter, the minimum magnetic field intensity required at the sensor to deactivate the switch is achieved at about -5 degrees of rotation, whereas with the vane interrupter, the maximum magnetic field intensity required at the sensor to deactivate the switch is achieved at about 5 degrees of rotation, a difference of about 10 degrees. Thus, with the vane interrupter, the switch need only travel about 7 degrees between levels of magnetic field required to activate and deactivate the switch, whereas with the vane interrupter, the switch must travel about 14 degrees to attain these field intensities. The arrangement without the vane interrupter necessitates a greater separation between the magnet and the sensor to effectively function. In other aspects, the sensors may be electromagnetic field sensors that act as transducers generating a signal proportional to one or more aspects of the electromagnetic fields generated my magnets, and positions may be resolved by, for example, software that determines positions based on signal strength and activates the switch based on such determined position.

## Claims

1. A switch (101) comprising:
a switch housing (126);
a button (102) moveably mounted to the housing (126);
a magnet holder (114) including at least one magnet (112, 112a, 112b) and moveably mounted to the housing (126);
a magnet sensor (123; 123a) mounted to the housing (126) and configured to measure an intensity of a magnetic field generated by the at least one magnet (112, 112a, 112b);
a vane interrupter (116) having a passage (140) proximate to the magnet sensor (123; 123a) and configured to have an attenuating effect on the magnetic field generated by the at least one magnet (112, 112a, 112b); **characterised in that** the at least one magnet (112; 112a, 112b) is disposed within the passage (140), the magnetic holder (114) being configured to selectively move such that the at least one magnet (112, 112a, 112b) is selectively moveable at least partially within the passage (140) to a first position distal to the magnet sensor (123; 123a) and a second position proximate to the magnet sensor (123; 123a) relative to the first position; and
wherein the attenuating effect of the vane interrupter (116) on the magnetic field generated by the at least one magnet (112, 112a, 112b) is based on a change in position of the at least one magnet (112, 112a, 112b) within the passage (140) from the first position to the second position or the second position to the first position.

2. The switch of claim 1, wherein the vane interrupter (116) includes a first wall (900), second wall (902), third wall (904) and fourth wall (906), a portion of the first wall (900), the second wall (902), the third wall (904) and fourth wall (906) defining the passage (140).

3. The switch of claim 1 or 2, wherein the vane interrupter (116) includes a ferromagnetic material.

4. The switch of claim 1, wherein the vane interrupter (116) is fixed relative to the housing (126), and the magnet holder (114) is rotatably mounted to the housing (126).

5. The switch of claim 1, wherein the switch housing (126) includes a frame (120) and a back cover (124), the frame (120) disposed between the magnet sensor (123; 123a) and the magnet holder (114).

6. The switch of claim 1, further comprising:
a profile (103) disposed between an underside of the button (102) and the switch housing (126) and haying a profile contour (104); and
a plunger (106) disposed between the profile (103) and the switch housing (126) and having a first end (108) proximate to the profile contour (104).

7. The switch of claim 6, further comprising a plunger spring (107) disposed between the switch housing (126) and plunger (106), the plunger spring (107) biasing the plunger (106) toward the profile (103).

8. The switch of claim 1 or 6, wherein the second position is a terminal position, the magnet (112; 112a) spaced from the magnet sensor (123; 123a) when the magnet holder (114) is in the second position.

9. The switch of any one of the preceding claims, further comprising a second magnetic sensor (123b) mounted to the switch housing (126), wherein the vane interrupter (116) includes a second passage (140), the second passage (140) having an opening (144) proximate to the second magnetic sensor (123b); and the magnet holder (114) includes a second magnet (112b), and wherein the magnet holder (114) is selectively moveable at least partially within the second passage (140) to a third position distal to the second magnet sensor (123b) and a fourth position proximate to the second magnet sensor (123b) relative to the third position.

10. The switch of any one of the preceding claims, wherein the magnetic sensor (123; 123a, 123b) is a Hall effect sensor.

11. The switch of claim 9, wherein the fourth position is a terminal position, the second magnet (112b) spaced from the second magnet sensor (123b) when the magnet holder (114) is in the fourth position.

## Patentansprüche

1. Ein Schalter, der Folgendes aufweist:
ein Schaltergehäuse (126);
eine Taste (102), die beweglich an dem Gehäuse (126) angebracht ist;
einen Magnethalter (114), der wenigstens einen Magneten (112, 112a, 112b) aufweist und beweglich an dem Gehäuse (126) angebracht ist;
einen Magnetsensor (123; 123a), der an dem Gehäuse (126) angebracht ist und konfiguriert ist zum Messen einer Intensität eines Magnetfeldes, das von dem wenigstens einen Magneten (112, 112a, 112b) erzeugt wird;
einen Flügelunterbrecher (116) mit einem Durchlass (140), der körpernah zu dem Magnetsensor (123; 123a) ist und konfiguriert ist, um einen dämpfenden Effekt auf das Magnetfeld, das von dem wenigstens einen Magneten (112, 112a, 112b) erzeugt wird, zu haben; **dadurch gekennzeichnet, dass** der wenigstens eine Magnet (112; 112a, 112b) innerhalb des Durchlass (140) angeordnet ist, der Magnethalter (114) konfiguriert ist, dass er sich selektiv so bewegt, dass der wenigstens eine Magnet (112, 112a, 112b) selektiv bewegbar wenigstens teilweise innerhalb des Durchlass (140) zu einer ersten Position fern von dem Magnetsensor (123; 123a) und einer zweiten Position körpernah zu dem Magnetsensor (123; 123a) bezüglich der ersten Position ist; und
wobei der dämpfende Effekt des Flügelunterbrechers (116) auf das Magnetfeld, das von dem wenigstens einen Magneten (112, 112a, 112b) erzeugt wird, auf einer Veränderung in der Position des wenigstens einen Magneten (112, 112a, 112b) innerhalb des Durchlass (140) von der ersten Position zu der zweiten Position oder der zweiten Position zu der ersten Position basiert.

2. Schalter nach Anspruch 1, wobei der Flügelunterbrecher (116) eine erste Wand (900), eine zweite Wand (902), eine dritte Wand (904) und eine vierte Wand (906) aufweist, wobei ein Teil der ersten Wand (900), der zweiten Wand (902), der dritten Wand (904) und der vierten Wand (906) den Durchlass (140) definieren.

3. Schalter nach Anspruch 1 oder 2, wobei der Flügelunterbrecher (116) ein ferromagnetisches Material aufweist.

4. Schalter nach Anspruch 1, wobei der Flügelunterbrecher (116) relativ zu dem Gehäuse (126) fixiert ist und der Magnethalter (114) drehbar an dem Gehäuse (126) angebracht ist.

5. Schalter nach Anspruch 1, wobei das Schaltergehäuse (126) einen Rahmen (120) und eine hintere Abdeckung (124) aufweist, wobei der Rahmen (120) zwischen dem Magnetsensor (123; 123a) und dem Magnethalter (114) angeordnet ist.

6. Schalter nach Anspruch 1, der ferner Folgendes aufweist:
Ein Profil (103), das zwischen einer Unterseite der Taste (102) und dem Schaltergehäuse (126) angebracht ist und eine Profilkontur (104) besitzt; und
einen Plunger (106), der zwischen dem Profil (103) und dem Schaltergehäuse (126) angebracht ist und ein erstes Ende (108) körpernah zu der Profilkontur (104) besitzt.

7. Schalter nach Anspruch 6, der ferner eine Plunger-Feder (107) aufweist, die zwischen dem Schaltergehäuse (126) und dem Plunger (106) angeordnet ist, wobei die Plunger-Feder (107) den Plunger (106) zu dem Profil (103) vorspannt.

8. Schalter nach Anspruch 1 oder 6, wobei die zweite Position eine Endposition ist und der Magnet (112; 112a) von dem Magnetsensor (123; 123a) beabstandet ist, wenn der Magnethalter (114) in der zweiten Position ist.

9. Schalter nach einem der vorhergehenden Ansprüche, der ferner einen zweiten Magnetsensor (123b) aufweist, der an das Schaltergehäuse (126) angebracht ist, wobei der Flügelunterbrecher (116) einen zweiten Durchlass (140) aufweist, wobei der zweite Durchlass (140) eine Öffnung (144) körpernah zu dem zweiten Magnetsensor (123b) besitzt; und der Magnethalter (114) einen zweiten Magneten (112b) aufweist, und wobei der Magnethalter (114) selektiv bewegbar wenigstens teilweise innerhalb des zweiten Durchlass (140) zu einer dritten Position fern von dem zweiten Magnetsensor (123b) und einer vierten Position körpernah zu dem zweiten Magnetsensor (123b) bezüglich der dritten Position ist.

10. Schalter nach einem der vorhergehenden Ansprüche, wobei der Magnetsensor (123; 123a, 123b) ein Hall-Effekt-Sensor ist.

11. Schalter nach Anspruch 9, wobei die vierte Position eine Endposition ist und der zweite Magnet (112b) von dem zweiten Magnetsensor (123b) beabstandet ist, wenn der Magnethalter (114) in der vierten Position ist.

## Revendications

1. Commutateur (101) comprenant:
un boîtier de commutateur (126) ;
un bouton (102) monté de manière mobile sur le boîtier (126) ;
un support d'aimant (114) comprenant au moins un aimant (112, 112a, 112b) et étant monté de manière mobile sur le boîtier (126) ;
un capteur magnétique (123 ; 123a) monté sur le boîtier (126) et configuré pour mesurer une intensité d'un champ magnétique généré par ledit au moins un aimant (112, 112a, 112b) ;
un interrupteur à palette (116) ayant un passage (140) proche du capteur magnétique (123 ; 123a) et étant configuré pour avoir un effet d'atténuation sur le champ magnétique généré par ledit au moins un aimant (112, 112a, 112b) ; **caractérisé en ce que** ledit au moins un aimant (112 ; 112a, 112b) est disposé dans le passage (140), le support d'aimant (114) étant configuré pour se déplacer sélectivement de sorte que ledit au moins un aimant (112, 112a, 112b) est déplaçable sélectivement au moins partiellement dans le passage (140) vers une première position distale du capteur magnétique (123 ; 123a) et une deuxième position proche du capteur magnétique (123 ; 123a) par rapport à la première position ; et
dans lequel l'effet d'atténuation de l'interrupteur à palette (116) sur le champ magnétique généré par ledit au moins un aimant (112, 112a, 112b) est basé sur un changement de position dudit au moins un aimant (112, 112a, 112b) dans le passage (140) de la première position à la deuxième position ou de la deuxième position à la première position.

2. Commutateur selon la revendication 1, dans lequel l'interrupteur à palette (116) comprend une première paroi (900), une deuxième paroi (902), une troisième paroi (904) et une quatrième paroi (906), une portion de la première paroi (900), de la deuxième paroi (902), de la troisième paroi (904) et de la quatrième paroi (906) définissant le passage (140).

3. Commutateur selon la revendication 1 ou 2, dans lequel l'interrupteur à palette (116) comprend un matériau ferromagnétique.

4. Commutateur selon la revendication 1, dans lequel l'interrupteur à palette (116) est fixe par rapport au boîtier (126), et le support d'aimant (114) est monté de manière rotative sur le boîtier (126).

5. Commutateur selon la revendication 1, dans lequel le boîtier de commutateur (126) comprend un cadre (120) et un couvercle arrière (124), le cadre (120) étant disposé entre le capteur magnétique (123 ; 123a) et le support d'aimant (114).

6. Commutateur selon la revendication 1, comprenant en outre :
un profilé (103) disposé entre une face inférieure du bouton (102) et le boîtier de commutateur (126), et ayant un contour de profilé (104) ; et
un piston (106) disposé entre le profilé (103) et le boîtier de commutateur (126), et ayant une première extrémité (108) proche du contour de profilé (104).

7. Commutateur selon la revendication 6, comprenant en outre un ressort de piston (107) disposé entre le boîtier de commutateur (126) et le piston (106), le ressort de piston (107) poussant le piston (106) vers le profilé (103).

8. Commutateur selon la revendication 1 ou 6, dans lequel la deuxième position est une position de fin de course, l'aimant (122 ; 112a) étant espacé du capteur magnétique (123; 123a) lorsque le support d'aimant (114) est dans la deuxième position.

9. Commutateur selon l'une quelconque des revendications précédentes, comprenant en outre un deuxième capteur magnétique (123b) monté sur le boîtier de commutateur (126), dans lequel l'interrupteur à palette (116) comprend un deuxième passage (140), le deuxième passage (140) ayant une ouverture (144) proche du deuxième capteur magnétique (123b) ; et le support d'aimant (114) comprend un deuxième aimant (112b), le support d'aimant (114) étant déplaçable sélectivement au moins partiellement dans le deuxième passage (140) vers une troisième position distale du deuxième capteur magnétique (123b) et une quatrième position proche du deuxième capteur magnétique (123b) par rapport à la troisième position.

10. Commutateur selon l'une quelconque des revendications précédentes, dans lequel le capteur magnétique (123 ; 123a, 123b) est un capteur à effet Hall.

11. Commutateur selon la revendication 9, dans lequel la quatrième position est une position de fin de course, le deuxième aimant (112b) étant espacé du deuxième capteur magnétique (123b) quand le support d'aimant (114) est dans la quatrième position.
